Europäisches Patentamt

European Patent Office

Office européen des brevets

(11) Publication number: **0 053 504**
**B1**

(12) **EUROPEAN PATENT SPECIFICATION**

(45) Date of publication of patent specification: **12.10.88**

(21) Application number: **81305640.5**

(22) Date of filing: **27.11.81**

(51) Int. Cl.⁴: **G 11 C 11/40**

(54) Static semiconductor memory device.

(30) Priority: **28.11.80 JP 167472/80**

(43) Date of publication of application:
**09.06.82 Bulletin 82/23**

(45) Publication of the grant of the patent:
**12.10.88 Bulletin 88/41**

(84) Designated Contracting States:
**DE FR GB NL**

(56) References cited:
**US-A-3 727 188**
**US-A-3 848 236**
**US-A-4 005 393**
**US-A-4 164 791**

(73) Proprietor: **FUJITSU LIMITED**
**1015, Kamikodanaka Nakahara-ku**
**Kawasaki-shi Kanagawa 211 (JP)**

(72) Inventor: **Toyoda, Kazuhiro**
**39-1433, Sakuradai Midori-ku**
**Yokohama-shi Kanagawa 227 (JP)**
Inventor: **Sugo, Yasuhisa**
**3-25-13, Minamikoiwa**
**Edogawa-ku Tokyo 133 (JP)**

(74) Representative: **Fane, Christopher Robin King
et al**
**HASELTINE LAKE & CO. Hazlitt House**
**28 Southampton Buildings Chancery Lane**
**London, WC2A 1AT (GB)**

Courier Press, Leamington Spa, England.

## Description

The present invention relates to a static semiconductor memory device, having memory cells arranged in a matrix.

Such devices are known in which each memory cell consists of two cross-coupled driving transistors, and in which a bit line selection circuit is provided in each column for receiving a high potential selection signal when selected and for supplying a current to the selected column.

In recent years, semiconductor memory devices, especially static RAMs (random access memories) have greatly progressed in high integration, high speed operation, and low power consumption. The development of large memory capacities, however, has led to the demand for even higher speed operation and lower power consumption.

Fig. 1A of the accompanying drawings shows a circuit diagram illustrating a main portion of a conventional static bipolar RAM. In Fig. 1A, $MC_{11}$, $MC_{1n}$, $MC_{mn}$, ... represent memory cells arranged in a matrix having n columns $C_1$ to $C_n$ and m rows $R_1$ to $R_m$.

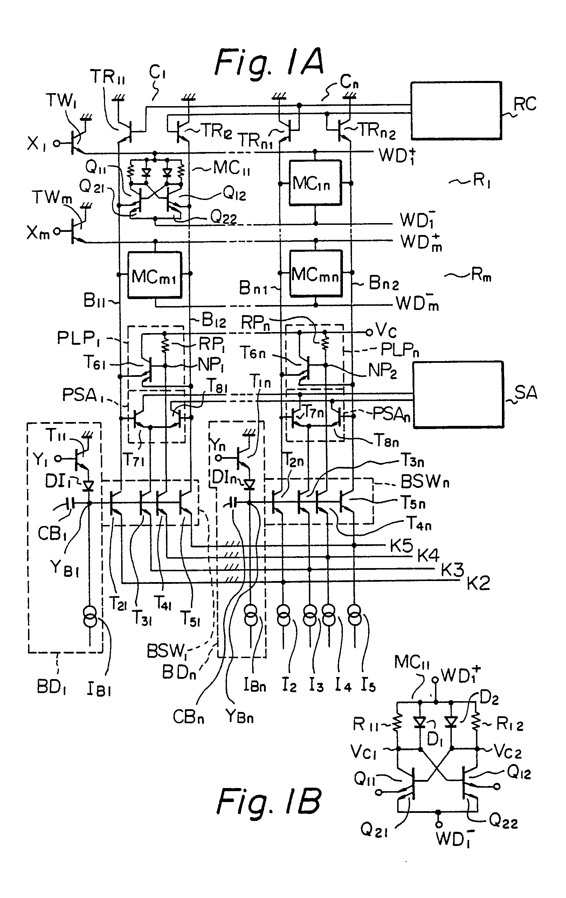

Fig. 1B of the accompanying drawings shows a circuit diagram illustrating the memory cell $MC_{11}$ of Fig. 1A in more detail. In Fig. 1B, the memory cell $MC_{11}$ consists of two driving transistors $Q_{11}$ and $Q_{12}$ and two memory storage transistors $Q_{21}$ and $Q_{22}$. The driving transistor $Q_{11}$ and the memory storage transistor $Q_{21}$ are constituted by a multi-emitter transistor. Similarly, the transistors $Q_{12}$ and $Q_{22}$ are constituted by another multi-emitter transistor. The collector of the transistor $Q_{11}$ is connected to the base of the transistor $Q_{12}$. Similarly, the collector of the transistor $Q_{12}$ is connected to the base of the transistor $Q_{11}$. Thus, the collectors of the transistors $Q_{11}$ and $Q_{12}$ are cross-coupled with each other. The emitters of the memory storage transistors $Q_{21}$ and $Q_{22}$ are commonly connected to a negative word line $WD_1^-$. Load resistors $R_{11}$ and $R_{12}$ are respectively connected between the collectors of the transistors $Q_{11}$ and $Q_{12}$ and a positive word line $WD_1^+$. Load diodes $D_1$ and $D_2$ are respectively connected between the collectors of the transistors $Q_{11}$ and $Q_{12}$ and the positive word line $WD_1^+$. When this memory cell $MC_{11}$ is selected, only one of the diodes $D_1$ and $D_2$ conducts current so as to supply a collector current to one of the memory storage transistors $Q_{21}$ and $Q_{22}$. Thus, the load diodes contribute to reducing power consumption. The other memory cells shown in Fig. 1A have a similar configuration to the memory cell $MC_{11}$.

Referring back to Fig. 1A, $WD_1^+$, ..., and $WD_m^+$ represent positive word lines connected to the emitters of word driving transistors $TW_1$, ..., and $TW_m$, respectively. The bases of the word driving transistors $TW_1$, ..., and $TW_m$ are adapted to receive word selection signals $X_1$, ..., and $X_m$, respectively. The collectors of the transistors $TW_1$, ..., and $TW_m$ are grounded. $WD_1^-$, ..., and $WD_m^-$ represent negative word lines, each of which is commonly connected to the emitters of the memory storage transistors of the corresponding row of memory cells, and is also connected to a holding current source (not shown).

$B_{11}$, $B_{12}$; ...; and $B_{n1}$, $B_{n2}$ represent respective pairs of bit lines connected to the emitters of the driving transistors $Q_{11}$, $Q_{12}$, ... of the corresponding columns of memory cells. The bit lines $B_{11}$, $B_{12}$, ..., $B_{n1}$, and $B_{n2}$ are connected to the emitters of transistors $TR_{11}$, $TR_{12}$, ..., $TR_{n1}$, and $TR_{n2}$, respectively. The bases of the transistors $TR_{11}$, $TR_{12}$, ..., $TR_{n1}$ and $TR_{n2}$ are connected to receive a reference potential for use in a reading operation, the reference potential being supplied by a reference potential setting circuit RC. The collectors of the transistors $TR_{11}$, $TR_{12}$, ..., $TR_{n1}$ and $TR_{n2}$ are grounded. $PSA_1$, ..., and $PSA_n$ are pre-sense amplifiers each consisting of a pair of transistors $T_{71}$, $T_{81}$; ...; or $T_{7n}$, $T_{8n}$, respectively. The bases of the transistors $T_{71}$, $T_{81}$, ..., $T_{7n}$ and $T_{8n}$ are connected to the bit lines $B_{11}$, $B_{12}$, ..., $B_{n1}$ and $B_{n2}$, respectively. The collectors of the transistors $T_{71}$, $T_{81}$, ..., $T_{7n}$, and $T_{8n}$ are commonly connected to a sense amplifier SA. $PLP_1$, ..., and $PLP_n$ represent pull-up circuits for charging up respective pairs of nonselected bit lines. Each pull-up circuit comprises a multi-emitter transistor $T_{61}$, ... or $T_{6n}$ having a first emitter connected to one bit line of the corresponding pair and a second emitter connected to the other of the bit lines concerned.

$BD_1$, ..., and $BD_n$ represent bit driver circuits. The bit driver circuit $BD_1$ comprises a transistor $T_{11}$, a diode $DI_1$, and a current source $IB_1$. The emitter of the transistor $T_{11}$ is connected to the anode of the diode $DI_1$. The cathode of the diode $DI_1$ is connected to the current source $IB_1$. The collector of the transistor $T_{11}$ is grounded. The base of the transistor $T_{11}$ is connected to a terminal $Y_1$ which is adapted to receive a column selection signal. The other bit driver circuits have a similar circuit configuration to the bit driver circuit $BD_1$.

$BSW_1$, ..., and $BSW_n$ represent bit selection circuits. The bit selection circuit $BSW_i$ consists of four transistors $T_{2i}$, $T_{3i}$, $T_{4i}$, and $T_{5i}$, where i represents the column number. The collector of the transistor $T_{2i}$ is connected to the bit line $B_{i1}$. The collector of the transistor $T_{5i}$ is connected to the bit line $B_{i2}$. The collector of the transistor $T_{3i}$ is connected to the coupled emitters of the transistors $T_{7i}$ and $T_{8i}$. The collector of the transistor $T_{4i}$ is connected to the base of the pull-up transistor $T_{6i}$. The emitters of the transistors $T_{2i}$ through $T_{5i}$ are connected through signal lines $K_2$, $K_3$, $K_4$, and $K_5$ respectively to current sources $I_2$, $I_3$, $I_4$, and $I_5$, respectively. The bases of the transistors $T_{2i}$, $T_{3i}$, $T_{4i}$, and $T_{5i}$ are commonly connected at a node $YB_i$ to the cathode of the diode $DI_i$. Thus, the transistors $T_{21}$, $T_{22}$, ..., and $T_{2n}$ constitute a current switch. Similarly, the other sets of transistors $T_{31}$ through $T_{3n}$, $T_{41}$ through $T_{4n}$, and $T_{51}$ through $T_{5n}$ constitute respective current switches. When one of the columns $C_i$ is to be selected, a high potential column selecting signal is applied through the terminal $Y_i$ to the bases of

the transistors $T_{2i}$ through $T_{5i}$ in the corresponding bit selection circuit $BSW_i$ so that these transistors are turned on to supply currents to the column $C_i$.

The operation of the conventional static bipolar RAM of Fig. 1 will now be briefly described. Assume that information is stored in the memory cell $MC_{11}$ in a state that the transistor $Q_{21}$ is in a conductive state and the transistor $Q_{22}$ is in a cut-off state. In this state, the potential $V_{c1}$ at the collector of the transistor $Q_{11}$ (see Fig. 1B) is at a low potential (hereinafter referred to as an "L level"), and the potential $V_{c2}$ at the collector of the transistor $Q_{12}$ is at a high potential (hereinafter referred to as a "H level"). When the memory cell $MC_{11}$ is selected by applying an H level signal to the terminal $X_1$ connected to the base of the transistor $TW_1$ and to the terminal $Y_1$ connected to the base of the transistor $T_{11}$, respectively, the transistor $TW_1$ is turned on so that the positive word line $WD_1^+$ is caused to be the H level, and, simultaneously, the transistor $T_{11}$ is turned on so that the node $YB_1$ is caused to be the H level. The other terminals $Y_2, \ldots,$ and $Y_n$ are all at the L level so that the nodes $YB_2, \ldots,$ and $YB_n$ are at the L level. Accordingly, only the transistors $T_{21}, T_{31}, T_{41},$ and $T_{51}$ in the selected bit selection circuit $BSW_1$ are turned on to supply currents from the current sources $I_2, I_3, I_4,$ and $I_5$ to the selected column $C_1$.

The emitter of the transistor $TR_{11}$ and the emitters of the driving transistors $Q_{11}$ in the memory cells $MC_{11}, \ldots,$ and $MC_{m1}$ are connected to the bit line $B_{11}$ to which the current $I_2$ is supplied when the transistor $T_{21}$ is turned on. Also, the emitter of the transistor $TR_{12}$ and the emitters of the driving transistors $Q_{12}$ in the memory cells $MC_{11}, \ldots,$ and $MC_{m1}$ are connected to the bit line $B_{12}$ to which the current $I_5$ is supplied when the transistor $T_{51}$ is turned on. In the memory cell $MC_{11}$, when the positive word line $WD_1^+$ is raised to the H level, so that the potential difference between the positive word line $WD_1^+$ and the node $V_{c1}$ exceeds the threshold voltage of the diode $D_1$, the diode $D_1$ begins to conduct current because the node $V_{c1}$ was at the L level, while the diode $D_2$ is kept in the cut-off state because the node $V_{c2}$ was at the H level. When the memory cell $MC_{11}$ has been selected, the potential at the nodes $V_{c1}$ and $V_{c2}$ become higher than those when the memory cell $MC_{11}$ is not selected. Also, the potential difference between the nodes $V_{c1}$ and $V_{c2}$ is increased. Then, the reference potential setting circuit RC applies an intermediate potential between the voltages $V_{c1}$ and $V_{c2}$ to the bases of the transistors $TR_{11}, TR_{12}, \ldots,$ $TR_{n1},$ and $TR_{n2}$. Because the base potential of the transistor $Q_{11}$ is $V_{c2}$, which is higher than the base potential of the transistor $TR_{11}$, the current switch constituted by the transistors $TR_{11}$ and $Q_{11}$ is operated to cause the transistor $Q_{11}$ to be kept turned on, while the transistor $TR_{11}$ is kept in the cut-off state. Also, because the base potential of the transistor $Q_{12}$ is $V_{c1}$, which is lower than the base potential of the transistor $TR_{12}$, the current switch constituted by the transistors $TR_{12}$ and $Q_{12}$ is operated to cause the transistor $TR_{12}$ to be turned on, while the transistor $Q_{12}$ is kept in the cut-off state. Thus, the transistor $Q_{11}$ conducts a current from the positive word line $WD_1^+$ to the bit line $B_{11}$, and the transistor $TR_{12}$ conducts current to the bit line $B_{12}$. The potential difference between the bit lines $B_{11}$ and $B_{12}$ is amplified by the pre-sense amplifier $PSA_1$ which consists of the transistors $T_{71}$ and $T_{81}$ having emitters commonly connected through the transistor $T_{31}$ to the current source $I_3$ to form a current switch. The amplified signal obtained between the collectors of the transistors $T_{71}$ and $T_{81}$ is further amplified by the sense amplifier SA.

In order to avoid unnecessary writing in the half-selected memory cells $MC_{12}, \ldots,$ and $MC_{1n}$, the driving transistors in these half-selected memory cells must be completely turned off. For this purpose, the pull-up circuits $PLP_2, \ldots, PLP_n$ operate so that the transistors $T_{62}, \ldots,$ and $T_{6n}$ included therein are turned on because the transistors $T_{42}, \ldots,$ and $T_{4n}$ are cut off, and, therefore, the bases of the transistors $T_{62}, \ldots,$ and $T_{6n}$ are at the H level. Thus, the bit lines $B_{21}, B_{22}, \ldots, B_{n1}$ and $B_{n2}$ are charged up to the H level by the power supply line $V_c$ through respective transistors $T_{62}, \ldots,$ and $T_{6n}$. This ensures the cut-off states of the driving transistors in the memory cells $MC_{12}, \ldots,$ and $MC_{1n}$.

A problem in the conventional static bipolar RAM of Fig. 1A will now be described. Referring to the bit selection circuit $BSW_i$ (i=1, 2, ..., or n), when one column $C_i$ is selected, a column selection signal is applied to the node $YB_i$ commonly connected to the bases of the transistors $T_{2i}, T_{3i}, T_{4i},$ and $T_{5i}$ in the bit selection circuit. When the column changes its state from a non-selected state to a selected state, the column selection signal rises from the L level to the H level. When the column changes its state from a selected state to a non-selected state, the column selection signal falls from the H level to the L level. In the conventional memory, however, there exists the disadvantage that the falling speed of the potential at the node $YB_i$ is low, so that the switching speed of the columns is low.

More specifically, the bit driver circuit $BD_i$ provided in each column comprises an emitter follower transistor $T_{1i}$, a level shifting diode $DI_i$, and a level shifting current source $IB_i$. When the potential at the terminal $Y_i$ is at the H level, the transistor $T_{1i}$ turns on to cause the node $YB_i$ to be the H level. When the terminal $Y_i$ is the L level, the transistor $T_{1i}$ turns off so that the node $YB_i$ becomes the L level. The H level at the node $YB_i$ is set by the transistor $T_{1i}$ and the diode $DI_i$ to a predetermined level lower than the potential at the collector of the transistor $T_{2i}, T_{3i}, T_{4i},$ or $T_{5i}$, so that the transistors $T_{2i}, T_{3i}, T_{4i},$ and $T_{5i}$ are not saturated. The bases of the transistors $T_{2i}, T_{3i}, T_{4i},$ and $T_{5i}$, the junction portion of the diode $DI_i$, and the wiring line for these bases have a parasitic capacitance $CB_i$. When the column $C_i$ changes its state from a selected state to a nonselected state,

the transistor $T_{1i}$ is turned off so that the potential at the node $YB_i$ falls. During falling of the potential at the node $YB_i$, the charges stored in the parasitic capacitance $CB_i$ should be discharged. Recent technology has increased memory capacities more and more with a corresponding increase in the number of the columns. The increase in the number of columns has been accompanied by an increase in the number of the current sources $IB_i$ as well, so that the power consumption tends to be increased. Also, the lengths of the wiring lines tend to become longer, so the parasitic capacitance tends to increase. In order to suppress the increase in the power consumption, the value of the current source $IB_i$ should be as small as possible. However, the smaller the value of the current source $IB_i$, the longer the time required for discharging the parasitic capacitance $CB_i$. Accordingly, the falling speed of the potential at the node $YB_i$ becomes low.

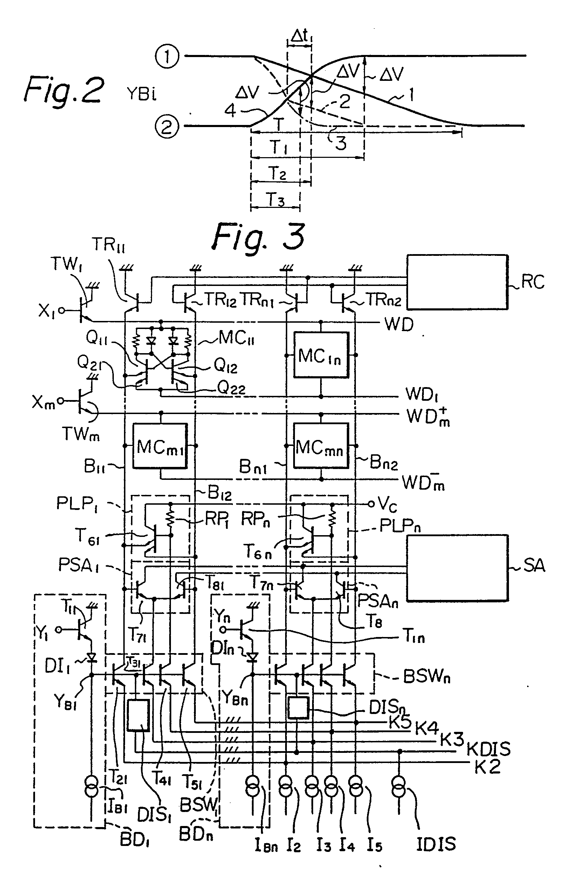

Fig. 2 is a time chart illustrating the changes of the potentials of the bit lines. In Fig. 2, ① represents a curve of the potential at the node $YB_i$ when the column $C_i$ changes from its selected state to the nonselected state. As can be seen from the curve ①, the falling time T is long. A curve ② is the curve of the potential at the node $YB_i$ when the column changes from its non-selected state to the selected state. As can be seen from the curve ②, the rising time $T_1$ is relatively small regardless of the value of the current $IB_i$ becuase the emitter-follower transistor $T_{1i}$ forces the node $YB_i$ to be driven to the H level. In a reading operation, the sense amplifier SA can detect, through the pre-sense amplifier, the potential difference between the bit lines $B_{11}$ and $B_{12}$ only after the potential difference between the curves ① and ② exceeds a predetermined value $\Delta V$. Therefore, the falling speed of the potential at the node $YB_i$ directly affects the access time of the memory.

The above-mentioned problem becomes more and more serious along with the increase in the memory capacity because the value of the current source $IB_i$ must be increasingly minimized so as to save on power consumption, along with the increase in the number of columns.

The present invention stems from a desire to decrease the falling time of the potential at the node $YB_i$.

According to the present invention there is provided a static semiconductor memory device comprising:

a plurality of memory cells arranged in a matrix having columns and rows;

a plurality of word lines connected to respective rows of the memory cells;

a plurality of bit lines, connected to respective columns of the memory cells, for receiving current when reading information stored in such cells or when writing information to be stored in such cells;

a plurality of bit selection circuits provided in the said columns, respectively; each of the said bit selection circuits comprising at least one bit selection transistor, connected between common current source means and a corresponding one of the said bit lines and having a control terminal connected to receive a column selection signal that has a first predetermined reference potential when the corresponding column is selected, for passing current between the said common current source means and the selected column; and

a plurality of bit driver circuits connected with the said columns, respectively; each of the said bit driver circuits being adapted to cause the said column selection signal to have the said first reference potential when the corresponding column is selected and to change that signal to a second predetermined reference potential for switching the column to a non-selected state;

the device being characterised by:

a plurality of auxiliary discharge paths, each of which is connected, between a common discharge current source and the control terminal of the said one bit selection transistor in an individually corresponding one of the said bit selection circuits, so as to be rendered conductive when the column selection signal received by that one bit selection transistor has the said first reference potential and so as to be maintained in the conductive state then for a period after that column selection signal begins to change from the said first reference potential to the second, thereby to increase the rate of change of potential of that column selection signal to the said second reference potential when switching of the corresponding column from the selected state to the non-selected state is initiated.

Preferably, the said auxiliary discharge paths comprise either respective discharge diodes or discharge transistors, each of the discharge transistors having a first load current terminal, for example a collector, connected to the control terminal (i.e. base) of the said one bit selection transistor in the corresponding bit selection circuit, and a second load current terminal, for example an emitter, connected to the said common discharge current source.

US—A—3,727,188 discloses discharge means operable to discharge the charge which has built up at the base of a selection transistor, in a selection unit, whilst a selection pulse was applied to that base. However, the disclosed discharge means are connected to receive an inverted form of the selection pulse, so as to be rendered operable when the selection pulse is turned off. Thus, in contrast to the present invention, in which the auxiliary discharge paths are rendered conductive when the column to which they correspond is selected, there is a delay between the time at which the selection pulse is switched off and that at which the discharge means of US—A—3,727,188 become conductive and begin to discharge the charge at the base of the selection transistor. In addition, in comparison to the memory device of the present invention, the circuitry of US—A—3,727,188 is more complex, since additional circuitry is required to provide an inverted form of the selection pulse.

Reference will now be made, by way of example, to the accompanying drawings, in which:

Fig. 1A (described above) shows a circuit diagram of a main portion of a conventional static bipolar RAM;

Fig. 1B (described above) shows a circuit diagram of a memory cell of the circuit of Fig. 1A in greater detail;

Fig. 2 shows a graph illustrating changes of bit line potentials in the circuit of Fig. 1A and in circuitry embodying the present invention;

Fig. 3 shows a circuit diagram of a main portion of a first static bipolar RAM embodying the present invention;

Fig. 4 shows a circuit diagram of part of the static bipolar RAM of Fig. 3;

Fig. 5 shows a circuit diagram of part of another static bipolar RAM embodying the present invention;

Fig. 6 shows a circuit diagram of part of yet another static bipolar RAM embodying the present invention; and

Fig. 7 shows a circuit diagram of part of a further static bipolar RAM embodying the present invention.

In contrast to Fig. 1, in Fig. 3 an auxiliary discharge path $DIS_i$ is connected to the bases of the transistors $T_{2i}$ through $T_{5i}$ in the bit selection circuit $BSW_i$. The other ends of the discharge paths $DIS_1, \ldots,$ and $DIS_n$ are commonly connected through a discharge signal line KDIS to a discharge current source IDIS.

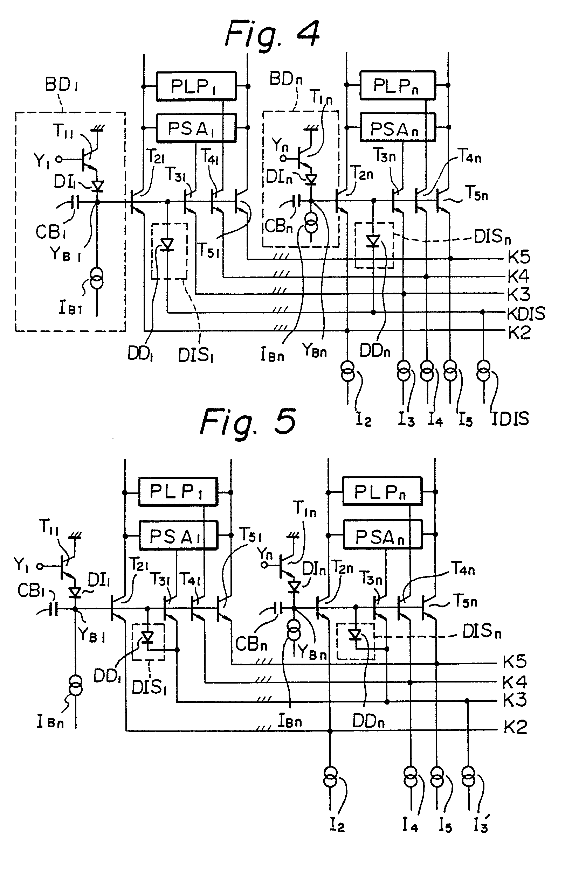

An embodiment of the present invention will now be described more particularly with reference to Fig. 4, in which a diode $DD_i$ is employed as a practical embodiment of each of the discharge paths $DIS_i$ of Fig. 3. All of the diodes $DD_1, \ldots,$ and $DD_n$ and the discharge current source IDIS constitute a current switch so that only one of the diodes is turned on to conduct a discharge current IDIS. The anode potential of the conductive diode, i.e. the potential at the node $YB_i$ in the selected column, is higher than that of each of the other diodes $DD_i$. Therefore, a current $IB_i+IDIS$ is conducted through the node $YB_i$ in the selected column; only the current $IB_i$ is conducted through each node $YB_i$ in the nonselected columns. Because of the large current $IB_i+IDIS$ in the selected bit driver circuit $BD_i$, the parasitic capacitance $CB_i$ is very rapidly discharged during the early stage of a switching when the column is switched from its selected state to the nonselected state. This causes a rapid fall of the potential at the node $YB_i$ and accordingly also of the potential of the bit line $B_{i1}$ when the column is switched from the selected state to the nonselected state, as illustrated by a broken-line curve 2 in Fig. 2. After the curve 2 crosses the rising curve 4, the column is changed to the nonselected state so that only the current $IB_i$ contributes to discharge the parasitic capacitance $CB_i$. Therefore, after that cross point, the curve 2 falls as slowly as the conventional fall curve 1. As a result, the time required for obtaining the predetermined potential difference $\Delta V$ between the bit lines $B_{i1}$ and $B_{i2}$ is $T_2$ which is considerably shorter than the time $T_1$ in the conventional circuit of Fig. 1. Thus, relatively high speed switching of the columns can be obtained, and, accordingly, the access time of the memory can be shortened. Although the discharge current source IDIS is added, the power consumption of the memory may not be significantly increased but may even be decreased in comparison with the power consumption in the conventional memory, because, in the circuit of Fig. 3, it is possible to make the current drawing capability of each current source $IB_i$ in each bit drive circuit $BD_i$ smaller than that in the circuit of Fig. 1.

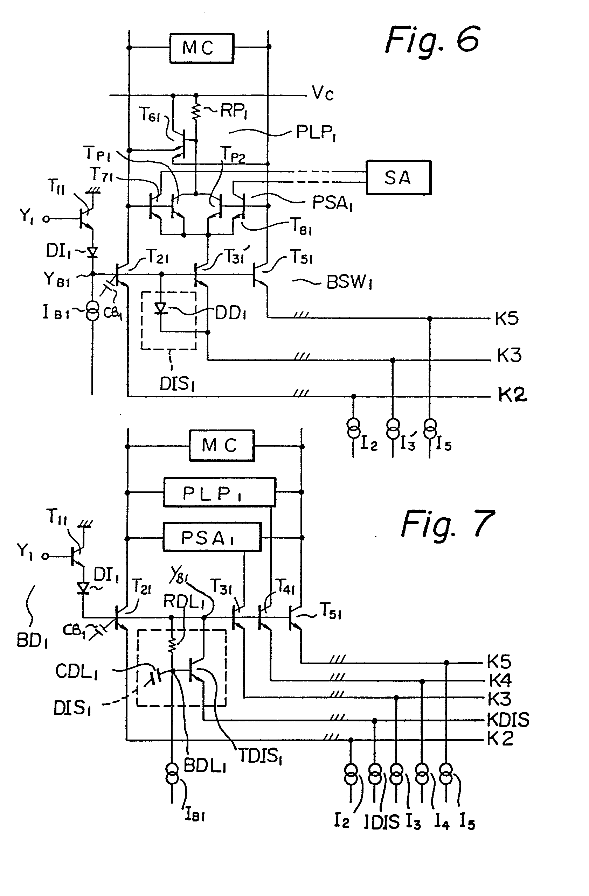

A second embodiment of the present invention will now be described with reference to Fig. 5, in which the cathode of a diode $DD_i$ in each discharge path $DIS_i$ is connected to the signal line $K_3$ which is connected to the emitter of the transistor $T_{3i}$ so that the discharge signal line KDIS in Fig. 4 is eliminated. In place of the current sources $I_3$ and IDIS, a current source $I_3'$, having a value $I_3+IDIS$, is connected to the signal line $K_3$. The ratio between the current $I_3$, which flows through the transistor $T_{3i}$ to the pre-sense amplifier $PLP_i$, and the current IDIS, which flows through the discharge diode $DD_i$, is determined by the ratio between the areas of the transistor $T_{3i}$ and the diode $DD_i$. Therefore, the ratio of these areas is designed to have a predetermined value. The diode $DD_i$ is made by a junction portion between the emitter and the base of a conventional transistor. Instead of connecting the cathode of the diode $DD_i$ to the signal line $K_3$ in the circuit of Fig. 5, the cathode may be connected to the signal line $K_4$ connected through the transistors $T_{41}, \ldots,$ and $T_{4n}$ to the pull-up circuits $PLP_1, \ldots,$ and $PLP_n$, respectively, which serve to charge up the non-selected bit lines.

A third embodiment of the present invention will now be described with reference to Fig. 6, in which the base of the transistor $T_{61}$ in the pull-up circuit $PLP_1$ is commonly connected to the collectors of transistors $T_{p1}$ and $T_{p2}$. The base and the emitter of the transistor $T_{p1}$ are connected to the base and the emitter of the transistor $T_{71}$, respectively. Also, the base and the emitter of the transistor $T_{p2}$ are connected to the base and the emitter of the transistor $T_{81}$, respectively. The emitters of the transistors $T_{71}, T_{p1}, T_{p2},$ and $T_{81}$ are commonly connected to the collector of a transistor $T_{31}'$ which takes the place of the transistor $T_{31}$ and $T_{41}$ in the circuit of Fig. 5. The emitter of the transistor $T_{31}'$ is connected through the signal line $K_3$ to a current source $I_3'$ which takes the place of the current sources $I_3$ and $I_4$ in the circuit of Fig. 4. The other columns have the same circuit configurations as the first column described above. This circuit configuration decreases the number of the transistors in each bit selection circuit $BSW_i$ to three, so that the parasitic capacitance $CB_i$ due to the base capacitances of these transistors can be reduced in comparison with the circuit of Fig. 5. Further, the number of signal lines

$K_2$, $K_3$, and $K_5$, each of which is commonly connected to all of the bit selection circuits $BSW_1$, . . ., and $BSW_n$, is decreased to three. The bit line pull-up circuit $PLP_i$ receives a current from the current source $I_3'$ through the signal line $K_3$, the transistor $T_{3i}'$ and the transistor $T_{p1}$ or $T_{p2}$. The pre-sense amplifier $PSA_i$ receives a current from the current source $I_3'$ through the transistor $T_{3i}'$. The discharge diode $DD_i$ is connected between the base and the emitter of the transistor $T_{31}'$ in a similar way to that in the circuit of Fig. 5.

In the foregoing embodiments, however, the discharge current IDIS is supplied to the node $YB_i$ in the column which is switched from the selected state to the nonselected state only in the first half switching period, because the discharge current IDIS flows through a discharge path $DIS_i$ connected to the node $YB_i$ which has the highest potential. Therefore, as illustrated in Fig. 2 by the dotted curve 2, after the cross point of the falling curve 2 and the rising curve ②, the falling speed of the curve 2 is lowered, with resulting residual restriction of the speed of operation.

In order to permit a higher speed of operation, an additional embodiment of the present invention is proposed and will now be described with reference to Fig. 7. The differences between the circuit of Fig. 4 and Fig. 7 are that, in Fig. 7, each discharge path $DIS_i$ comprises a transistor $TDIS_i$ having a collector connected to the node $YB_i$ and a base connected through a resistor $RDL_i$ to the node $YB_i$. A delay capacitor $CDL_i$ is connected to the base of the transistor $TDIS_i$. The emitter of the transistor $TDIS_i$ is connected through the signal line KDIS to the current source IDIS. In each bit drive circuit $BD_i$, the current source $IB_i$ is eliminated.

When a column is switched from the selected state to the nonselected state, the charge on the node $YB_i$ in that column is discharged through the transistor $TDIS_i$ in that column so that the potential at that node $YB_i$ is lowered. However, the fall of the base potential $BDL_i$ of the transistor $TDIS_i$ in that column is delayed in comparison with the fall of the potential at the node $YB_i$ due to a time constant derived from the resistor $RDL_i$ and the capacitor $CDL_i$. Therefore, the transistor $TDIS_i$ in that column continues to discharge after the potential at the node $YB_i$ is sufficiently lowered. On the other hand, when another column is switched from the nonselected state to the selected state, the rise of the base potential $BDL_i$ of the transistor $TDIS_i$ in this column is also delayed in comparison with the rise of the potential at the node $YB_i$ due to the time constant derived from the resistor $RDL_i$ and the capacitor $CDL_i$. Therefore, the transistor $TDIS_i$ in this column is kept cut-off after the potential at the node $YB_i$ in that column sufficiently rises. Thus, as illustrated in Fig. 2 by a dash dot curve 3, the falling curve 3 falls more rapidly than the curve 2 because the discharge current IDIS flows through the discharge path even after the falling curve 3 crosses with the rising curve ②. As a result, the time required for obtaining the predetermined difference between the bit lines $B_{11}$ and $B_{12}$ is $T_3$, which is the shortest of all the embodiments described above.

It should be noted that although the column selection signal is described above as changing from the high potential to the low potential when the column is switched from the selected state to the nonselected state, an embodiment of the present invention may also be applied to the case where the column selection signal changes from the low potential to the high potential when the column is switched from the selected state to the nonselected state.

## Claims

1. A static semiconductor memory device comprising:

a plurality of memory cells ($MC_{11}$, . . ., $MC_{mn}$) arranged in a matrix having columns and rows;

a plurality of word lines (WD) connected to respective rows of the memory cells;

a plurality of bit lines ($B_{11}$, $B_{12}$; . . .; $B_{n1}$, $B_{n2}$), connected to respective columns of the memory cells, for receiving current when reading information stored in such cells or when writing information to be stored in such cells;

a plurality of bit selection circuits ($BSW_1$, . . ., $BSW_n$) provided in the said columns, respectively; each of the said bit selection circuits comprising at least one bit selection transistor ($T_{21}$, . . ., $T_{2n}$), connected between common current source means ($I_2$) and a corresponding one of the said bit lines ($B_{11}$, . . ., $B_{n1}$) and having a control terminal connected to receive a column selection signal that has a first predetermined reference potential when the corresponding column is selected, for passing current between the said common current source means ($I_2$) and the selected column; and

a plurality of bit driver circuits ($BD_1$, . . ., $BD_n$) connected with the said columns, respectively; each of the said bit driver circuits being adapted to cause the said column selection signal to have the said first reference potential when the corresponding column is selected and to change that signal to a second predetermined reference potential for switching the column to a nonselected state;

the device being characterised by:

a plurality of auxiliary discharge paths ($DIS_1$, . . ., $DIS_n$), each of which is connected between a common discharge current source (IDIS; $I_3'$) and the control terminal of the said one bit selection transistor ($T_{21}$, . . ., $T_{2n}$) in an individually corresponding one of the said bit selection circuits ($BSW_1$, . . ., $BSW_n$), so as to be rendered conductive when the column selection signal received by that one bit selection transistor ($T_{21}$, . . ., $T_{2n}$) has the said first reference potential and so as to be maintained in the conductive state then for a period after that column selection signal begins to change from the said first reference potential to the second, thereby to increase the rate of change of potential of that column selection signal to the said second reference potential when switching of the corresponding column from the selected state to the non-selected state is initiated.

2. A device as claimed in claim 1, wherein the said auxiliary discharge paths (DIS$_1$, . . ., DIS$_n$) comprise respective discharge diodes (DD$_1$, . . ., DD$_n$).

3. A device as claimed in claim 2, wherein each of the said discharge diodes (DD$_1$, . . ., DD$_n$) has a cathode connected to the said common discharge current source (IDIS).

4. A device as claimed in claim 2 or 3, wherein each of the said discharge diodes (DD$_1$, . . ., DD$_n$) has an anode connected to the control terminal of the said one bit selection transistor (T$_{21}$, . . ., T$_{2n}$) in the said corresponding bit selection circuit (BSW$_1$, . . ., BSW$_n$).

5. A device as claimed in claim 1, wherein each of the said auxiliary discharge paths (DIS$_1$) comprises a discharge transistor (TDIS$_1$), and a delay circuit (RDL$_1$, CDL$_1$) connected to supply the said column selection signal to the control terminal of the said discharge transistor.

6. A device as claimed in claim 5, wherein each of the said discharge transistors (TDIS$_1$) has a first load current terminal connected to the control terminal of the said one bit selection transistor (T$_{21}$) in the corresponding bit selection circuit and a second load current terminal connected to the said common discharge current source (IDIS).

7. A device as claimed in any preceding claim, wherein each of the said bit selection circuits (BSW$_1$, . . ., BSW$_n$) also comprises a further bit selection transistor (T$_{31}'$, . . .), having a first load current terminal connected to further common current source means (I$_3$, I$_3'$), and wherein each of the said columns includes a pull-up circuit (PLP$_1$, . . ., PLP$_n$), for charging up the bit lines (B$_{11}$, B$_{12}$; . . .; B$_{n1}$, B$_{n2}$) of that column when the column concerned is in a non-selected state, and a pre-sense amplifier (PSA$_1$, . . ., PSA$_n$), for amplifying potential difference between the bit lines of the column concerned; the said further bit selection transistor (T$_{31}'$, . . .) in each of the said bit selection circuits having a second load current terminal connected, through a current switch in the corresponding pre-sense amplifier (PSA$_1$, . . ., PSA$_n$), to the corresponding pull-up circuit (PLP$_1$, . . ., PLP$_n$).

8. A device as claimed in any preceding claim, wherein the said common current source means (I$_3'$) also constitute the said discharge current source (IDIS).

## Patentansprüche

1. Statische Halbleiterspeichervorrichtung mit:
einer Vielzahl von Speicherzellen (MC$_{11}$, . . ., MC$_{mn}$), die in einer Matrix angeordnet sind, welche Spalten und Reihen hat;
einer Vielzahl von Wortleitungen (WD), die mit jeweiligen Reihen der Speicherzellen verbunden sind;
einer Vielzahl von Bitleitungen (B$_{11}$, B$_{12}$; . . .; B$_{n1}$, B$_{n2}$), die mit jeweiligen Spalten der Speicherzellen verbunden sind, um Strom zu empfangen, beim Lesen von Information, die in solchen Zellen gespeichert ist, oder, beim Schreiben von Information, die solche Zellen gespeichert werden soll;
einer Vielzahl von Bitauswahlschaltungen (BSW$_1$, . . ., BSW$_n$), die jeweils in den genannten Spalten vorgesehen sind; wobei jede der genannten Bitauswahlschaltungen wenigstens einen Bitauswahltransistor (T$_{21}$, . . ., T$_{2n}$) umfaßt, der zwischen gemeinsamen Stromquelleneinrichtungen (I$_2$) und einer entsprechenden der genannten Bitleitungen (B$_{11}$, . . ., B$_{n1}$) angeschlossen ist und einen Steueranschluß hat, der verbunden ist, um ein Spaltenauswahlsignal zu empfangen, das ein erstes vorbestimmtes Referenzpotential hat, wenn die entsprechende Spalte ausgewählt wird, um Strom zwischen der genannten gemeinsamen Stromquelleneinrichtungen (I$_2$) und der ausgewählten Spalte zu führen; und
einer Vielzahl von Bittreiberschaltungen (BD$_1$, . . ., BD$_n$), die jeweils mit den genannten Spalten verbunden sind; wobei jede der genannten Bittreiberschaltungen angepaßt ist, um zu bewirken, daß das genannte Spaltenauswahlsignal das genannte erste Referenzpotential hat, wenn die korrespondierende Spalte ausgewählt ist, und um das Signal auf ein zweites vorbestimmtes Referenzpotential zu ändern, um die Spalte in einen nicht ausgewählten Zustand zu schalten;
welche Vorrichtung gekennzeichnet ist durch:
eine Vielzahl von Hilfsentladungswegen (DIS$_1$, . . ., DIS$_n$), von denen jeder zwischen einer gemeinsamen Entladungsstromquelle (IDIS; I$_3'$) und dem Steueranschluß des genannten einen Bitauswahltransistors (T$_{21}$) in einer individuell entsprechenden von den genannten Bitauswahlschaltung (BSW$_1$, . . ., BSW$_n$) verbunden ist, um leitend gemacht zu werden, wenn das Spaltenauswahlsignal, welches von dem einen Bitauswahltransistor (T$_{21}$, . . ., T$_{2n}$) empfangen wird, das genannte erste Referenzpotential hat, und um dann in dem leitenden Zustand gehalten zu werden, für eine Periode nachdem das Spaltenauswahlsignal beginnt, sich von dem genannten ersten Referenzpotential auf das zweite zu ändern, um dadurch die Geschwindigkeit der Änderung des Potentials von jenem Spaltenauswahlsignal auf das genannte zweite Referenzpotential zu erhöhen, wenn die Umschaltung der entsprechenden Spalte aus dem ausgewählten Zustand in den nicht-ausgewählten Zustand initiiert wird.

2. Vorrichtung nach Anspruch 2, bei der die genannten Hilfsentladungswege (DIS$_1$, . . ., DIS$_n$) jeweils entsprechende Entladungsdioden (DD$_1$, . . ., DD$_n$) umfassen.

3. Vorrichtung nach Anspruch 2, bei der jede der genannten Entladungsdioden (DD$_1$, . . ., DD$_n$) eine Kathode hat, die mit der gemeinsamen Entladungsstromquelle (IDIS) verbunden ist.

4. Vorrichtung nach Anspruch 2 oder 3, bei der jede der genannten Entladungsdioden (DD$_1$, . . ., DD$_n$) eine Anode hat, die mit dem Steueranschluß des genannten einen Bitauswahltransistors (T$_{21}$, . . ., T$_{2n}$) in der genannten entsprechenden Bitauswahlschaltung (BSW$_1$, . . ., BSW$_n$) verbunden ist.

5. Vorrichtung nach Anspruch 1, bei der jeder der genannten Hilfsentladungswege (DIS$_1$) einen Entladungstransistor (TDIS$_1$) und eine Verzögerungsschaltung (RDL$_1$, CDL$_1$) umfaßt, die angeschlossen sind, um das genannte Spaltenauswahlsignal an den Steueranschluß des genannten Entladungstransistors zu liefern.

6. Vorrichtung nach Anspruch 5, bei der jeder der genannten Entladungstransistoren (TDIS$_1$) einen ersten Laststromanschluß hat, der mit dem Steueranschluß des genannten einen Bitauswahltransistors (T$_{21}$) in der entsprechenden Bitauswahlschaltung verbunden ist, und einen zweiten Laststromanschluß, der mit der genannten gemeinsamen Entladungsstromquelle (IDIS) verbunden ist.

7. Vorrichtung nach einem der vorhergehenden Ansprüche, bei der jede der genannten Bitauswahlschaltungen (BSW$_1$, . . ., BSW$_n$) außerdem einen weiteren Bitauswahltransistor (T$_{31}'$, . . .) umfaßt, der einen ersten Laststromanschluß hat, der mit einer weiteren gemeinsamen Stromquelleneinrichtungen (I$_3$, I$_3'$) verbunden ist, und bei der jede der genannten Spalten eine Pull-up-Schaltung (PLP$_1$, . . ., PLP$_n$) umfaßt, zum Aufladen der Bitleitungen (B$_{11}$, B$_{12}$; . . .; B$_{n1}$, B$_{n2}$) jener Spalte, wenn die betreffende Spalte in einem nichtausgewählten Zustand ist, und einen Vor-Leseverstärker (PSA$_1$, . . ., PSA$_n$), zum Verstärken der Potentialdifferenz zwischen den Bitleitungen der betreffenden Spalte; wobei der weitere Bitauswahltransistor (T$_{31}'$, . . .) in jeder der genannten Bitauswahlschaltungen einen zweiten Laststromanschluß hat, der, über einen Stromschalter dem entsprechenden Vor-Leseverstärker (PSA$_1$, . . ., PSA$_n$) mit der entsprechenden Pull-up-Schaltung (PLP$_1$, . . ., PLP$_n$) verbunden ist.

8. Vorrichtung nach einem der vorhergehenden Ansprüche, bei der die genannte gemeinsame Stromquelleneinrichtungen (I$_3'$) auch die Entladungsstromquelle (IDIS) bildet.

**Revendications**

1. Dispositif de mémoire semiconductrice statique comprenant:

plusieurs cellules de mémoire (MC$_{11}$, . . ., MC$_{mn}$) disposées en une matrice qui possède des colonnes et des rangées;

plusieurs lignes de mot (WD) connectées à des rangées respectives des cellules de mémoire;

plusieurs lignes de bit (B$_{11}$, B$_{12}$; . . .; B$_{n1}$, B$_{n2}$), connectées à des colonnes respectives des cellules de mémoire, et destinées à recevoir un courant pendant la lecture d'une information emmagasinée dans ces cellules ou pendant l'écriture d'une information à emmagasiner dans ces cellules;

plusieurs circuits de sélection de bit (BSW$_1$, . . ., BSW$_n$) respectivement disposés dans lesdites colonnes; chacun desdits circuits de sélection de bit comprenant au moins un transistor de sélection de bit (T$_{21}$, . . ., T$_{2n}$), connecté entre un moyen de source de courant commun (I$_2$) et l'une correspondante desdites lignes de bit (B$_{11}$, . . ., B$_{n1}$) et possédant une borne de commande qui est connectée de façon à recevoir un signal de sélection de colonne possédant un premier potentiel de référence prédéterminé lorsque la colonne correspondante est sélectionnée, afin de laisser passer un courant entre ledit moyen de source de courant commun (I$_2$) et la colonne sélectionnée; et

plusieurs circuits d'excitation de bit (BD$_1$, . . ., BD$_n$) respectivement connectés auxdites colonnes; chacun desdits circuits d'excitation de bit étant conçu pour amener ledit signal de sélection de colonne à posséder ledit premier potentiel de référence lorsque la colonne correspondante est sélectionnée et à changer ce signal en un deuxième potentiel de référence prédéterminé pour la commutation de la colonne à un état non sélectionné; le dispositif étant caractérisé par:

plusieurs trajets de décharge auxiliaires (DIS$_1$, . . ., DIS$_n$), qui sont chacun connectés entre une source de courant de décharge commune (IDIS; I$_3'$) et la borne de commande dudit transistor de sélection de bit (T$_{21}$, . . ., T$_{2n}$) de celui desdits circuits de sélection de bit (BSW$_1$, . . ., BSW$_n$) qui lui correspond de manière particulière, de façon à être rendu conducteur lorsque le signal de sélection de colonne reçu par ce transistor de sélection de bit (T$_{21}$, . . ., T$_{2n}$) possède ledit premier potentiel de référence et de façon à le maintenir dans l'état conducteur par la suite, pendant une certaine durée après que le signal de sélection de colonne a commencé à passer dudit premier potentiel de référence au second, de manière à augmenter la vitesse de variation du potentiel de ce signal de sélection de colonne vers ledit deuxième potentiel de référence lorsque la commutation de la colonne correspondante de l'état sélectionné à l'état non sélectionné commence.

2. Dispositif selon la revendication 1, où lesdits trajets de décharge auxiliaires (DIS$_1$, . . ., DIS$_n$) comprennent des diodes de décharge respectives (DD$_1$, . . ., DD$_n$).

3. Dispositif selon la revendication 2, où chacune desdites diodes de décharge (DD$_1$, . . ., DD$_n$) possède une cathode qui est connectée à ladite source de courant de décharge commune (IDIS).

4. Dispositif selon la revendication 2 ou 3, où chacune desdites diodes de décharge (DD$_1$, . . ., DD$_n$) possède une anode connectée à la borne de commande dudit transistor de sélection de bit (T$_{21}$, . . ., T$_{2n}$) appartenant audit circuit de sélection de bit (BSW$_1$, . . ., BSW$_n$) correspondant.

5. Dispositif selon la revendication 1, où chacun desdits trajets de décharge auxiliaires (DIS$_1$) comprend un transistor de décharge (TDIS$_1$) et un circuit de retard (RDL$_1$, CDL$_1$) qui sont connectés de manière à fournir ledit signal de sélection de colonne à la borne de commande dudit transistor de décharge.

6. Dispositif selon la revendication 5, où chacun desdits transistors de décharge (TDIS$_1$) possède une première borne de courant de charge qui est connectée à la borne de commande dudit transistor de sélection de bit (T$_{21}$) du circuit de sélection de bit correspondant et une deuxième borne de courant de charge connectée à ladite source de courant de décharge commune (IDIS).

7. Dispositif selon l'une quelconque des revendications précédentes, où chacun desdits circuits de sélection de bit (BSW$_1$, ..., BSW$_n$) comprend également un transistor de sélection de bit supplémentaire (T$_{31}$', ...), ayant une première borne de courant de charge connectée à un moyen de source de courant commun supplémentaire (I$_3$, I$_3$'), et où chacune desdites colonnes comporte un circuit de tirage vers le haut (PLP$_1$, ..., PLP$_n$), afin de charger les lignes de bit (B$_{11}$, B$_{12}$; ...; B$_{n1}$, B$_{n2}$) de cette colonne lorsque la colonne considérée est dans un état non sélectionné, et un amplifica-teur de prélecture (PSA$_1$, ..., PSA$_n$), servant à amplifier la différence de potentiel entre les lignes de bit de la colonne considérée; ledit transistor de sélection de bit supplémentaire (T$_{31}$', ...) de chacun desdits circuits de sélection de bit possédant une deuxième borne de courant de charge connectée, via un commutateur de courant se trouvant dans l'amplificateur de prélecture cor-respondant (PSA$_1$, ..., PSA$_n$), au circuit de tirage vers le haut correspondant (PLP$_1$, ..., PLP$_n$).

8. Dispositif selon l'une quelconque des revendications précédentes, où ledit moyen de source de courant commun (I$_3$') constitue également ladite source de courant de décharge (IDIS).

# Fig. IA

# Fig. IB

Fig.2

Fig. 3

## Fig. 4

## Fig. 5

*Fig. 6*

*Fig. 7*